# FASCICULE DE BREVET EUROPEEN

(11) **EP 1 846 956 B1**
(45) Date de publication et mention de la délivrance du brevet: **21.01.2009**
(21) Numéro de dépôt: 06709480.5
(22) Date de dépôt: 06.02.2006
(51) Int. Cl.: H01L 31/0224, H01L 31/18, H01L 27/142, H01L 21/28

(54) **PROCEDE DE REALISATION DE CONTACTS METAL/SEMI-CONDUCTEUR A TRAVERS UN DIELECTRIQUE**
VERFAHREN ZUR HERSTELLUNG VON METALL-/HALBLEITERKONTAKTEN ÜBER EIN DIELEKTRIKUM
METHOD FOR PRODUCING METAL/SEMICONDUCTOR CONTACTS THROUGH A DIELECTRIC

(30) Priorité: 08.02.2005 FR 0550357
(43) Date de publication de la demande: 24.10.2007
(73) Titulaire: COMMISSARIAT A L'ENERGIE ATOMIQUE, 75015 Paris (FR)
(72) Inventeur: RIBEYRON, Pierre Jean, F-38330 Saint Ismier (FR); ROLLAND, Emmanuel, F-38560 Jarrie (FR)
(74) Mandataire: Poulin, Gérard
(86) Numéro de dépôt international: PCT/FR2006/050101
(87) Numéro de publication internationale: WO 2006/085021

(56) Documents cités:
- WO-A-02/25742
- US-A- 4 626 613
- US-A- 4 703 553
- US-A- 5 011 565
- US-A1- 2002 153 039
- US-A1- 2004 097 062
- HO A W Y ET AL: "Buried contact solar cells with innovative rear localised contacts" PROGRESS IN PHOTOVOLTAICS: RESEARCH AND APPLICATIONS WILEY UK, vol. 12, no. 4, juin 2004 (2004-06), pages 297-308, XP002349703 ISSN: 1062-7995
- SCHNEIDERLOECHNER E ET AL: "LASER-FIRED REAR CONTACTS FOR CRYSTALLINE SILICON SOLAR CELLS" PROGRESS IN PHOTOVOLTAICS. RESEARCH AND APPLICATIONS, JOHN WILEY AND SONS, CHICHESTER, GB, vol. 10, no. 1, janvier 2002 (2002-01), pages 29-34, XP001112408 ISSN: 1062-7995
- METZ A ET AL: "High-quality passivated rear contact structure for silicon solar cells based on simple mechanical abrasion" CONFERENCE RECORD OF THE TWENTY-EIGHTH IEEE PHOTOVOLTAIC SPECIALISTS CONFERENCE - 2000 (CAT. NO.00CH37036) IEEE PISCATAWAY, NJ, USA, 2000, pages 172-175, XP002349704 ISBN: 0-7803-5772-8
- PREU R ET AL: "Laser ablation- A new low-cost approach for passivated rear contact formation in crystalline silicon solar cell technology" PROCEEDINGS OF THE EUROPEAN PHOTOVOLTAIC SOLAR ENERGY CONFERENCE, vol. II, 1 mai 2000 (2000-05-01), pages 1181-1184, XP002200822
- GUO J-H ET AL: "LASER-GROOVED BACKSIDE CONTACT SOLAR CELLS WITH 680-MV OPEN-CIRCUIT VOLTAGE" IEEE TRANSACTIONS ON ELECTRON DEVICES, IEEE SERVICE CENTER, PISACATAWAY, NJ, US, vol. 51, no. 12, décembre 2004 (2004-12), pages 2186-2192, XP001214247 ISSN: 0018-9383
- MOON I S ET AL: "New method for patterning the rear passivation layers of high-efficiency solar cells" JOURNAL OF MATERIALS SCIENCE: MATERIALS IN ELECTRONICS KLUWER ACADEMIC PUBLISHERS/CHAPMAN & HALL USA, vol. 12, no. 10, octobre 2001 (2001-10), pages 605-607, XP002349705 ISSN: 0957-4522
- COTTER J E ET AL: "Novel processes for simplified buried contact solar cells" CONFERENCE RECORD OF THE 28TH IEEE PHOTOVOLTAIC SPECIALISTS CONFERENCE, vol. CONF. 28, 15 septembre 2000 (2000-09-15), pages 303-306, XP002200820 ISBN: 0-7803-5773-6

## Description

### DOMAINE TECHNIQUE

La présente invention se rapporte à un procédé de réalisation de contacts métal/semi-conducteur à travers un diélectrique, spécialement adapté à la réalisation de dispositifs semiconducteurs. Un tel procédé peut être, par exemple, utilisé pour la réalisation de contacts métal/semi-conducteur sur la face arrière d'une cellule solaire à homojonction.

### ÉTAT DE LA TECHNIQUE ANTÉRIEURE

La fabrication de cellules solaires au niveau industriel suit deux objectifs : augmenter le rendement des cellules solaires et augmenter la productivité de fabrication de ces cellules solaires. La majorité des cellules solaires fabriquées sont à base de silicium cristallin. On distingue deux types de cellules solaires : les cellules solaires à hétérojonction et les cellules solaires à homojonction.

Le procédé de fabrication classique d'une cellule solaire à homojonction au silicium cristallin est le suivant :
un substrat de silicium dopé N ou P est placé dans un four de diffusion pour former, sur une de ses faces, une zone dopée P+ si le silicium est dopé N, ou N+ si le silicium est dopé P. Cette face du substrat est appelée « émetteur ». Elle se trouve du côté de la face avant de la cellule solaire. Une couche métallique, par exemple en aluminium, est déposée sur une autre face, opposée à l'émetteur. Cette autre face est appelée « base ». Le substrat et la couche métallique sont recuits afin de surdoper la base du substrat du même type de conductivité que le substrat. Une zone dopée N+ si le silicium est dopé N, ou P+ si le silicium est dopé P, se forme sur toute la base du substrat. Cette cuisson permet d'assurer un bon contact entre la couche métallique et la base du substrat. Une couche antiréflective est ensuite déposée sur l'émetteur du substrat semi-conducteur. Cette couche antiréflective permet d'assurer une perte optique minimum en « piégeant » les photons à l'intérieur de la cellule solaire. Cette couche peut, par exemple, être réalisée en nitrure de silicium ou en oxyde de titane. Une grille métallique est alors réalisée sur la couche antiréflective. Cette grille métallique doit assurer un ombrage minimum de la face avant afin que la surface de l'émetteur exposée à la lumière soit la plus grande possible. Elle est recuite afin qu'elle traverse la couche antiréflective et vienne en contact avec l'émetteur du substrat semi-conducteur.

Afin d'obtenir un meilleur rendement, la face arrière de la cellule solaire ne doit pas être contactée entièrement par la couche métallique en aluminium. En effet, pour obtenir une cellule à haut rendement, il ne suffit pas d'avoir un bon contact entre les différentes couches de la cellule. Il faut également que les surfaces, et en particulier la face arrière, soient parfaitement passivées. Une bonne passivation de surface signifie que les porteurs minoritaires, c'est-à-dire les électrons dans du silicium de type P, créés par l'absorption de photons par la cellule solaire ne vont pas, ou très peu, se recombiner à la surface considérée. Dans les cellules solaires industrielles, la passivation de la face arrière est réalisée par un effet de champ arrière (connu sous la dénomination anglo-saxonne BSF pour Back Surface Field). Ce BSF est créé par un recuit de la couche métallique en aluminium se trouvant sur la base du substrat, qui induit un surdopage du même type de conductivité que le substrat sur toute la surface de la base.

Toutefois, cette passivation de surface par surdopage de toute la surface de la base du substrat n'est pas aussi efficace que la passivation de surface par diélectrique. La passivation de surface par diélectrique consiste à déposer sur la surface à passiver une couche de diélectrique. Le diélectrique utilisé peut être par exemple de l'oxyde de silicium ou du nitrure de silicium.

Le meilleur compromis est donc de contacter une fraction de la face arrière de la cellule solaire avec un métal afin d'obtenir des points de contact métal/semi-conducteur, et d'occuper le reste de cette face arrière par un dépôt de diélectrique présentant les meilleures caractéristiques possibles en matière de passivation de surface. Cette structure est plus complexe à mettre en oeuvre que celle utilisant un surdopage de l'ensemble de la surface à passiver. Elle nécessite le plus souvent d'utiliser des étapes coûteuses de photolithographie.

Les brevets US-A-4 626 613 et US-A-5 011 565 décrivent des cellules solaires ayant des points de contact métal/semi-conducteur à travers une couche diélectrique. Dans ces deux brevets, le diélectrique est tout d'abord déposé sur la base du substrat de silicium. Un laser grave ensuite à travers le diélectrique les emplacements des contacts métalliques. Enfin, le métal est déposé dans les emplacements gravés. Ce procédé présente l'inconvénient que le substrat est endommagé par le laser et qu'une étape supplémentaire de gravure dans les emplacements des contacts métalliques est nécessaire pour permettre un contact de bonne qualité.

Le brevet EP-A1-1319254 décrit également une cellule solaire ayant des contacts métal/semi-conducteur à travers une couche diélectrique. Le diélectrique est déposé sur une face d'un substrat de silicium. Une couche métallique est ensuite déposée sur la couche de diélectrique par pulvérisation cathodique ou évaporation. Une source laser réalise ensuite des contacts ponctuels en chauffant localement la couche métallique. Le métal fondu par la source laser traverse le diélectrique et fusionne avec le silicium pour créer les contacts métal/semi-conducteur. L'inconvénient majeur de ce procédé est qu'il ne permet pas d'avoir une bonne productivité. En effet, le laser doit réaliser entre 100 et plus de 500 points de fusion par cellule, ce qui demande un temps de réalisation important. De plus, le laser peut endommager la surface métallique, créant une surépaisseur sur la face arrière de la cellule, source de détérioration lors de l'interconnexion entre plusieurs cellules.

Le document "Buried contact solar cells with innovative rear localised contacts", Ho et al., Progress in Photovoltaics: Research and applications, vol. 12, no. 4, juin 2004, pages 297-308 décrit un procédé de réalisation de contacts entre une couche métallique et un substrat semi-conducteur à travers une couche de diélectrique. Le dispositif semi-conducteur comporte sur sa base la couche de diélectrique sur laquelle est empilée la couche métallique. Un traitement thermique à basse température (< 577°C) est effectué afin de localement réduire l'oxyde de silicium et de former ainsi les contacts.

Dans les documents "Laser-fired rear contacts for crystalline silicon solar cells", Schneiderlöchner et al., Progress in Photovoltaics : Research and applications, vol. 10, no. 1, janvier 2002, pages 29-34 et US 2004/097062 A1, une source de radiation ou source laser chauffe localement la couche métallique et le métal fondu traverse la couche d'oxide de silicium et fusionne avec le silicium du substrat.

Dans les documents "High-quality passivated rear contact structure for silicon solar cells based on simple mechanical abrasion", Metz et al., Conférence record of the 28th IEEE Photovoltaic specialists conférence, 2000, pages 172-175 et "New method for patterning the rear passivation layers of high-efficiency solar cells", Moon et al., Journal of Materials Science: Materials in Electronics, vol. 12, no. 10, octobre 2001, pages 605-607, des ouvertures dans la couche d'oxide de silicium sont obtenues par abrasion méchanique et le contact d'aluminium ou de AI/Ti/Pd est obtenu par évaporation.

Dans le document "Laser ablation - A new low-cost approach for passivated rear contact formation in crystalline silicon solar cell technology", Preu et el., Proceedings of the European Photovoltaic Solar Energy Conférence, vol. Il, 1 mai 2000, pages 1181-1184, les emplacements pour des contacts dans la couche de nitrure sont obtenus par ablation laser. Ensuite la couche métallique d'aluminium est déposée par PVD.

Dans le document "Laser-grooved backside contact solar cells with 680-mV open-circuit voltage", Guo et al., IEEE Transactions on electron devices, vol. 51, no. 12, décembre 2004, pages 2186-2192, les emplacements des contacts dans la couche d'oxide sont gravés par ablation laser. Ensuite les contacts métalliques sont obtenus par électrodéposition.

Dans le document "Novel processes for simplified buried contact solar cells", Cotter et al., Conférence record of the 28th IEEE Photovoltaic specialists conference, 2000, pages 303-306, une couche métallique est directement déposée sur le substrat et chauffé localement par une source laser afin de réaliser des contacts à travers une éventuelle couche d'oxide.

Dans le document US 4 703 553, une couche métallique (aluminium) est déposée sur une couche d'oxide ou de nitrure de silicium et les contacts sont obtenus par échauffement à des températures entre 400°C et 600°C.

Dans le document US 2002/153039, les emplacements pour les contacts sont gravés par HF dans la couche de diélectrique et la couche métallique est ensuite réalisée par électrodéposition.

### EXPOSÉ DE L'INVENTION

La présente invention a pour but de proposer un procédé de réalisation de contacts métal/semi-conducteur à travers un diélectrique pour un dispositif semi-conducteur, ne présentant pas les inconvénients des procédés antérieurs de réalisation de contacts métal/semi-conducteur à travers un diélectrique, notamment leur productivité réduite et leurs risques de détérioration sur les dispositifs réalisés.

Pour atteindre ces buts, la présente invention propose un procédé de réalisation de contacts entre au moins une couche métallique et au moins un substrat semi-conducteur à travers au moins une couche de diélectrique dans un dispositif semi-conducteur qui comporte, sur au moins une face, appelée « base », du substrat semi-conducteur, la couche de diélectrique sur laquelle est empilée la couche métallique. Des extrémités chauffées de plusieurs éléments en saillie montés sur un support sont mises en contact avec la couche métallique simultanément, créant ainsi des zones de métal fondu sous les extrémités chauffées des éléments en saillie, le métal fondu traversant le diélectrique et fusionnant avec le semi-conducteur du substrat au niveau des zones de métal fondu, créant ainsi les contacts.

Ainsi, au lieu de réaliser des contacts ponctuels successifs sur un dispositif semi-conducteur, entre une couche de semi-conducteur et une couche métallique, à travers une couche de diélectrique, avec une source laser, on réalise tous les contacts en une seule fois en utilisant des éléments en saillie dont les extrémités chauffées sont placées contre la couche métallique simultanément. Sous ces extrémités chauffées, des zones de métal fondu se forment alors par conduction, traversent le diélectrique et fusionnent avec le semi-conducteur du substrat, créant ainsi les contacts entre la couche métallique et le semi-conducteur. La couche de diélectrique réalise la passivation de la face arrière du substrat semi-conducteur.

Il est préférable que les éléments en saillie soient disposés en matrice sur le support.

On peut envisager que les extrémités des éléments en saillie soient chauffées à une température comprise entre environ 577°C et 1000°C, afin de faire fondre rapidement la couche métallique.

Il est préférable que le temps d'application des extrémités chauffées des éléments en saillie contre la couche métallique soit compris entre environ 0.5 seconde et 10 secondes.

Le nombre d'éléments en saillie, utilisés pour une surface de substrat semi-conducteur d'environ 1m², peut être compris par exemple, entre environ 500 et 35000.

Les extrémités des éléments en saillie peuvent être de forme sensiblement circulaire dont le diamètre peut être compris entre environ 50 micromètres et 1 millimètre, ou sensiblement en forme de quadrilatère dont les côtés peuvent avoir une dimension comprise entre environ 50 micromètres et 1 millimètre. La forme des extrémités des éléments en saillie est identique à la forme des contacts métal/semi-conducteur réalisés par ces éléments en saillie.

Il est préférable que le substrat semi-conducteur soit un substrat cristallin.

Le substrat semi-conducteur peut être par exemple en silicium monocristallin ou en silicium polycristallin.

On peut envisager que la couche de diélectrique soit en oxyde de silicium ou en nitrure de silicium.

La couche de diélectrique est de préférence déposée sur le substrat semi-conducteur par une technique de dépôt chimique en phase vapeur assisté par plasma.

La couche métallique peut être par exemple déposée sur la couche de diélectrique par évaporation, pulvérisation ou sérigraphie.

On peut envisager que la couche métallique ait une épaisseur comprise entre environ 1 micromètre et 5 micromètres.

La couche métallique peut être à base d'un matériau dopant tel que l'aluminium.

Il est alors préférable que le substrat semi-conducteur soit d'un premier type de conductivité et que durant le procédé de réalisation des contacts, le métal fondu crée des zones de surdopage du premier type de conductivité dans le substrat semi-conducteur, autour des contacts métal/semi-conducteur. Ces zones permettent ainsi d'avoir un bon contact entre la couche métallique et le substrat semi-conducteur.

La présente invention concerne également un procédé de réalisation d'un dispositif semi-conducteur comportant des contacts réalisés selon le procédé décrit précédemment, dans lequel le substrat semi-conducteur est de préférence d'un premier type de conductivité. Ce procédé de réalisation de dispositif semi-conducteur peut comporter les étapes suivantes :
a) cuisson du substrat semi-conducteur, formant, sous une autre face appelée « émetteur », opposée à la base, une région surdopée d'un second type de conductivité, opposé au premier type de conductivité ;
b) réalisation d'une couche antiréflective sur l'émetteur du substrat semi-conducteur ;
c) dépôt d'une grille métallique sur la couche antiréflective ;
d) mise en contact de la grille métallique avec l'émetteur du substrat semi-conducteur à travers la couche antiréflective.

La mise en contact de la grille métallique avec l'émetteur du substrat semi-conducteur à travers la couche antiréflective peut être réalisée par une cuisson de la grille métallique.

La grille métallique peut par exemple être à base d'un métal noble tel que l'argent. Cette grille métallique est une des deux électrodes du dispositif semi-conducteur, l'autre étant la couche métallique.

La couche antiréflective peut par exemple être en nitrure de silicium ou en oxyde de titane.

Un tel dispositif semi-conducteur peut être avantageusement une cellule solaire.

La présente invention concerne également un dispositif à éléments en saillie pour la mise en oeuvre du procédé décrit précédemment. On peut envisager que ce dispositif comporte des éléments en saillie montés sur un support commun incluant des moyens de chauffage.

Les extrémités des éléments en saillie peuvent être pointues.

Les éléments en saillie peuvent être réalisés à base de graphite ou de tungstène.

Il est préférable que les moyens de chauffage soient un élément résistif ou inductif.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente en coupe un exemple de dispositif semi-conducteur comportant des contacts métal/semi-conducteur à travers un diélectrique réalisés suivant un procédé de réalisation, objet de la présente invention. La figure 1 comporte également des éléments en saillie, utilisés pendant le procédé de réalisation des contacts métal/semi-conducteur à travers le diélectrique ;
- les figures 2A à 2C représentent des vues en coupe des étapes d'un procédé de réalisation de contacts métal/semi-conducteur à travers un diélectrique, objet de la présente invention ;
- la figure 3A représente une vue de dessous d'éléments en saillie disposés en matrice sur un même support ;
- la figure 3B représente une vue en perspective d'éléments en saillie disposés en matrice sur un même support.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

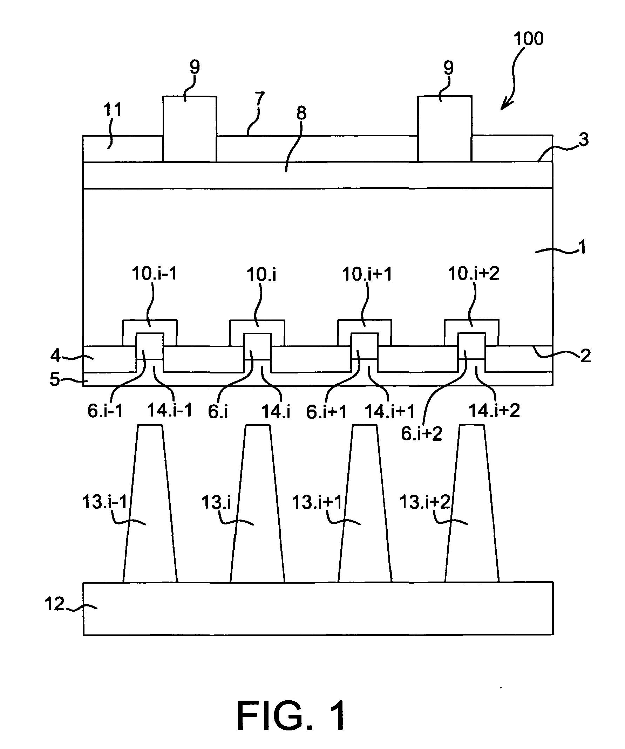

On se réfère à la figure 1 qui montre en coupe un exemple de dispositif semi-conducteur 100 réalisé selon un procédé de réalisation, objet de la présente invention. Il comporte sur au moins une face 2, appelée « base », d'un substrat semi-conducteur 1, une couche de diélectrique 4. Sur cette couche de diélectrique 4 est empilée une couche métallique 5. Le dispositif semi-conducteur 100 comporte également des contacts 6.1 à 6.n entre la couche métallique 5 et le substrat semi-conducteur 1, traversant la couche de diélectrique 4, réalisés suivant un procédé de réalisation, également objet de la présente invention. Sur la figure 1, seuls quatre contacts 6.i-1, 6.1, 6.i+1, 6.i+2 faisant partie de l'ensemble des contacts 6.1 à 6.n sont représentés. Dans cet exemple, il s'agit d'une cellule solaire, mais il pourrait s'agir d'un autre dispositif semi-conducteur.

Le substrat semi-conducteur 1 peut être un substrat cristallin, par exemple en silicium monocristallin ou en silicium polycristallin. Il peut également être, par exemple, en couche mince. Il possède un premier type de conductivité. Dans l'exemple illustré sur la figure 1, le substrat semi-conducteur 1 est du silicium cristallin de type P. L'épaisseur du substrat semi-conducteur 1 peut être comprise entre 10 micromètres et quelques centaines de micromètres.

Le substrat semi-conducteur 1 comporte également une autre face 3 appelée « émetteur », opposée à la base 2. Cet émetteur 3 est du côté d'une face avant 7 du dispositif semi-conducteur 100. L'exemple de dispositif semi-conducteur 100 de la figure 1 étant une cellule solaire, c'est cette face avant 7 qui est exposée à la lumière.

Le dispositif semi-conducteur 100 comporte sous l'émetteur 3 du substrat semi-conducteur 1 une région 8 surdopée d'un second type de conductivité, opposé au premier type de conductivité. Dans l'exemple de la figure 1, il s'agit donc d'une région 8 dopée N+. Cette région est réalisée par une cuisson, par exemple dans un four de diffusion, du substrat semi-conducteur 1.

Une couche antiréflective 11 est ensuite déposée sur la région 8 du substrat semi-conducteur 1. Cette couche antiréflective 11 permet d'assurer une perte optique minimum en « piégeant » les photons à l'intérieur du dispositif semi-conducteur 100. Cette couche 11 peut, par exemple, être réalisée en nitrure de silicium ou en oxyde de titane.

Une grille métallique 9 est ensuite réalisée sur la couche antiréflective 11. Cette grille métallique 9 est la deuxième électrode du dispositif semi-conducteur 100. Elle est réalisée par exemple à base d'un métal noble tel que l'argent. Elle doit assurer un ombrage minimum de la face avant 7 afin que la surface de cette face avant 7 exposée à la lumière soit la plus grande possible. Cette grille métallique 9 est par exemple réalisée par un dépôt de pâte de sérigraphie qui est ensuite recuite afin qu'elle traverse la couche antiréflective 11 et vienne en contact avec la région 8.

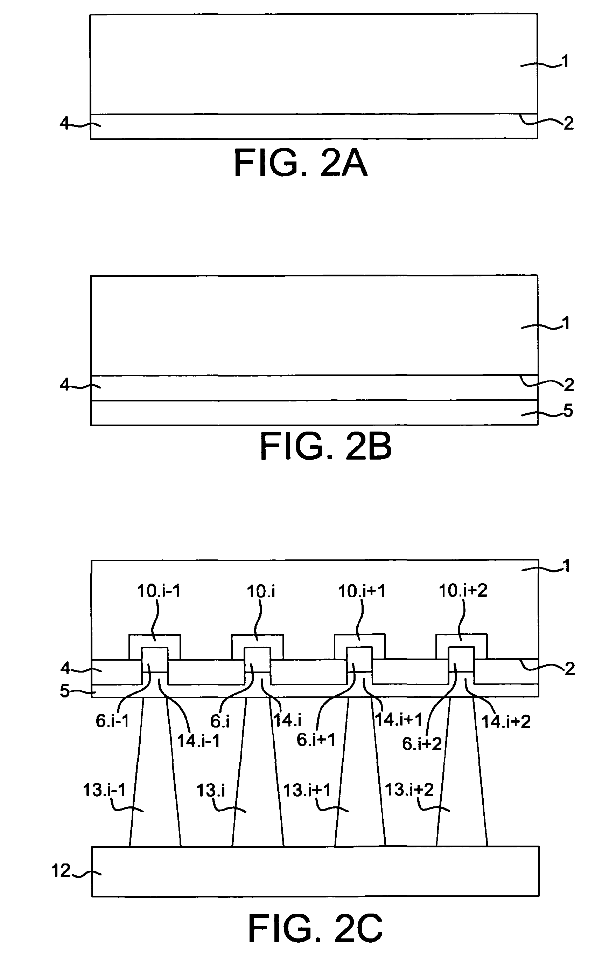

On va maintenant s'intéresser au procédé de réalisation de contacts métal/semi-conducteur à travers un diélectrique, également objet de la présente invention, faisant partie du procédé de réalisation du dispositif semi-conducteur 100 de la figure 1. Sur les figures 2A à 2C, seuls le substrat semi-conducteur 1 et les éléments du dispositif semi-conducteur 100 se trouvant du côté de la base 2 du substrat semi-conducteur 1 sont représentés. En effet, les éléments représentés sur la figure 1 se trouvant du côté de l'émetteur 3 du substrat semi-conducteur 1 ne sont qu'un mode de réalisation préféré du dispositif semi-conducteur 100.

Comme on peut le voir sur la figure 2A, au moins la couche de diélectrique 4 est tout d'abord déposée sur au moins la base 2 du substrat semi-conducteur 1. Cette couche de diélectrique 4 permet d'assurer une bonne passivation de la base 2 du substrat semi-conducteur 1. Cela signifie que les porteurs minoritaires créés par l'absorption de photons ne vont pas ou très peu se recombiner à la surface considérée, c'est-à-dire la base 2 du substrat semi-conducteur 1. Dans l'exemple représenté sur les figures 1 à 2C, la couche de diélectrique 4 est en nitrure de silicium ou en oxyde de silicium. Le dépôt de cette couche de diélectrique 4 est par exemple réalisé par une technique de dépôt chimique en phase vapeur assisté par plasma (connu sous la dénomination anglo-saxonne PECVD pour Plasma Enhanced Chemical Vapor Deposition), ou une toute autre technique appropriée. L'épaisseur de cette couche de diélectrique 4 est comprise entre environ 5 nanomètres et 100 nanomètres.

Le substrat semi-conducteur 1 et la couche de diélectrique 4 sont ensuite cuits à une température d'environ 400°C pour améliorer les propriétés de passivation de la couche de diélectrique 4.

Une couche métallique 5 est ensuite empilée sur la couche de diélectrique 4, comme cela est illustré sur la figure 2B. Cette couche métallique 5 est une des deux électrodes du dispositif semi-conducteur 100. Dans l'exemple de cette figure 2B, la couche métallique 5 est en aluminium. Elle est déposée par évaporation, pulvérisation ou encore par sérigraphie. Son épaisseur est comprise entre environ 1 micromètres et 5 micromètres.

Plusieurs extrémités chauffées d'éléments en saillie 13.1 à 13.n sont ensuite appliquées simultanément contre la couche métallique 5. Sur la figure 2C et sur la figure 1, ces éléments en saillie sont disposés en matrice sur un même support 12. Leurs extrémités sont par exemple pointues. Sur ces deux figures, seuls quatre éléments en saillie 13.i-1, 13.i, 13.i+1, 13.i+2 sont représentés sur le support 12. La couche métallique 5 se trouvant sous les extrémités chauffées des éléments en saillie 13.1 à 13.n commence à fondre légèrement par radiation lorsque les extrémités chauffées sont rapprochées de la surface du métal. Lorsque les extrémités chauffées des éléments en saillie 13.1 à 13.n sont mises en contact avec la couche métallique 5, le métal se trouvant sous les extrémités chauffées fond rapidement par conduction pour former des zones de métal fondu 14.1 à 14.n. Une partie du métal fondu touchant le semi-conducteur du substrat 1 fusionne alors avec celui-ci et forme des contacts 6.1 à 6.n reliant électriquement le substrat semi-conducteur 1 et la couche métallique 5. Le nombre de contacts 6.1 à 6.n est égal au nombre d'éléments en saillie 13.1 à 13.n que comporte le support 12. Le temps d'application des extrémités chauffées des éléments en saillie 13.1 à 13.n contre la couche métallique 5 est par exemple compris entre environ 0.5 seconde et 10 secondes. Ces éléments en saillie 13.1 à 13.n sont chauffées à une température comprise environ entre 577°C et 1000°C. Pendant ce temps d'application, si la couche métallique 5 a des propriétés dopantes, comme sur l'exemple de la figure 2C et de la figure 1 dont la couche métallique 5 est en aluminium, et que le substrat semi-conducteur 1 est d'un premier type de conductivité, des zones de surdopage 10.1 à 10.n du premier type de conductivité se forment autour des contacts 6.1 à 6.n. Ces zones de surdopage 10.1 à 10.n permettent d'assurer un meilleur contact entre le substrat semi-conducteur 1 et la couche métallique 5.

Après la réalisation des contacts 6.1 à 6.n, le métal des zones de métal fondu 14.1 à 14.n qui n'a pas fusionné avec le semi-conducteur du substrat 1 se solidifie pour revenir dans le même état que le reste du métal de la couche métallique 5.

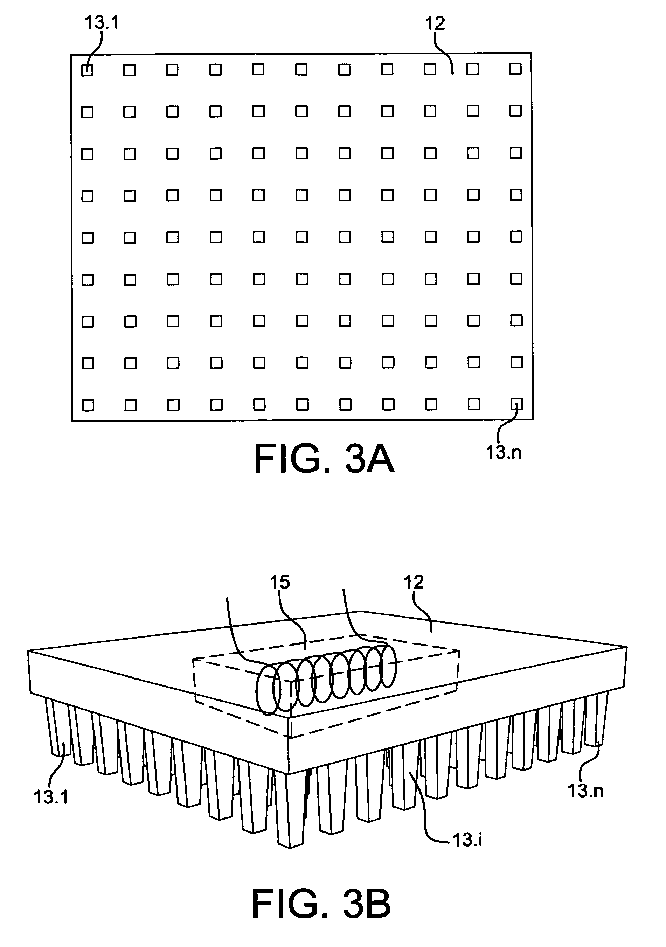

Les surfaces des contacts 6.1 à 6.n se trouvant contre la couche métallique 5 ont la même forme que les extrémités des éléments en saillie 13.1 à 13.n. Sur les figures 3A et 3B est illustré un exemple de support 12 et d'éléments en saillie 13.1 à 13.n, vus du dessous et vus en perspective. On voit que les éléments en saillie 13.1 à 13.n ont chacune une extrémité de forme carré, dont les côtés ont une dimension d'environ 250 micromètres. Ils sont disposés en matrice, régulièrement espacés d'une distance environ égale à 2 millimètres. D'une manière générale, les extrémités des éléments en saillie 13.1 à 13.n peuvent être sensiblement en forme de quadrilatère dont les côtés ont une dimension comprise entre environ 50 micromètres et 1 millimètre, ou de forme sensiblement circulaire dont le diamètre est compris entre environ 50 micromètres et 1 millimètre. Entre environ 500 et 35000 éléments en saillie peuvent être utilisés pour une surface de substrat semi-conducteur d'environ 1m². Les éléments en saillie 13.1 à 13.n sont par exemple réalisées à base de graphite ou de tungstène.

Une première méthode de fabrication consiste à utiliser une rectifieuse qui va directement créer les éléments en saillie 13.1 à 13.n à partir d'un bloc massif de graphite ou de tungstène. Dans cette méthode de fabrication, le support 12 et les éléments en saillie 13.1 à 13.n sont réalisés à partir d'un même bloc de graphite ou de tungstène. Une deuxième méthode de fabrication consiste à réaliser des trous dans un bloc de graphite ou tungstène qui est le support 12. Ces trous sont réalisés conformément au motif de la matrice des éléments en saillie 13.1 à 13.n. Ces éléments en saillie 13.1 à 13.n, réalisés à partir d'un autre bloc de graphite ou tungstène, sont ensuite insérés dans les trous précédemment réalisés. Dans ces deux méthodes de fabrication, des moyens de chauffage 15, comme par exemple une résistance sur la figure 3B, sont ensuite intégrés à l'intérieur du support 12. Ce sont ces moyens de chauffage 15 qui permettent de chauffer les éléments en saillie 13.1 à 13.n. Plus généralement, ces moyens de chauffage peuvent être par exemple un élément inductif ou résistif.

L'avantage de ce procédé est qu'il est rapide puisque le traitement du substrat de semi-conducteur est réalisé en une seule opération. De plus, il est facilement automatisable et permet un gain significatif en terme de rendement tout en maintenant une très bonne productivité, compatible avec une production industrielle.

## Revendications

1. Procédé de réalisation de contacts (6.1 à 6.n) entre au moins une couche métallique (5) et au moins un substrat semi-conducteur (1) à travers au moins une couche de diélectrique (4) dans un dispositif semi-conducteur (100), ledit dispositif semi-conducteur (100) comportant, sur au moins une face (2), appelée « base », du substrat semi-conducteur (1), la couche de diélectrique (4) sur laquelle est empilée la couche métallique (5), **caractérisé en ce que** des extrémités chauffées de plusieurs éléments en saillie (13.1 à 13.n) montés sur un support (12) sont mises en contact avec la couche métallique (5) simultanément, créant ainsi des zones de métal fondu (14.1 à 14.n) sous les extrémités chauffées des éléments en saillie (13.1 à 13.n), le métal fondu traversant le diélectrique (4) et fusionnant avec le semi-conducteur du substrat (1) au niveau des zones de métal fondu (14.1 à 14.n), créant ainsi les contacts (6.1 à 6.n).

2. Procédé selon la revendication 1, **caractérisé en ce que** les éléments en saillie (13.1 à 13.n) sont disposés en matrice sur le support (12).

3. Procédé selon l'une quelconque des revendications précédentes, **caractérisé en ce que** les extrémités des éléments en saillie (13.1 à 13.n) sont chauffées à une température comprise entre 577°C et 1000°C.

4. Procédé selon l'une quelconque des revendications précédentes, **caractérisé en ce que** le temps d'application des extrémités chauffées des éléments en saillie (13.1 à 13.n) contre la couche métallique (5) est compris entre 0.5 seconde et 10 secondes.

5. Procédé selon l'une quelconque des revendications précédentes, **caractérisé en ce qu'**entre 500 et 35000 éléments en saillie (13.1 à 13.n) sont utilisés pour une surface de substrat semi-conducteur (1) d'1m².

6. Procédé selon l'une quelconque des revendications précédentes, **caractérisé en ce que** les extrémités des éléments en saillie (13.1 à 13.n) sont de forme circulaire dont le diamètre est compris entre 50 micromètres et 1 millimètre, ou en forme de quadrilatère dont les côtés ont une dimension comprise entre 50 micromètres et 1 millimètre.

7. Procédé selon l'une quelconque des revendications précédentes, **caractérisé en ce que** le substrat semi-conducteur (1) est un substrat cristallin.

8. Procédé selon l'une quelconque des revendications précédentes, **caractérisé en ce que** le substrat semi-conducteur (1) est en silicium monocristallin ou en silicium polycristallin.

9. Procédé selon l'une quelconque des revendications précédentes, **caractérisé en ce que** la couche de diélectrique (4) est en oxyde de silicium ou en nitrure de silicium.

10. Procédé selon l'une quelconque des revendications précédentes, **caractérisé en ce que** la couche de diélectrique (4) est déposée sur le substrat semi-conducteur (1) par une technique de dépôt chimique en phase vapeur assisté par plasma.

11. Procédé selon l'une quelconque des revendications précédentes, **caractérisé en ce que** la couche métallique (5) est déposée sur la couche de diélectrique (4) par évaporation, pulvérisation ou sérigraphie.

12. Procédé selon l'une quelconque des revendications précédentes, **caractérisé en ce que** la couche métallique (5) a une épaisseur comprise entre 1 micromètre et 5 micromètres.

13. Procédé selon l'une quelconque des revendications précédentes, **caractérisé en ce que** la couche métallique (5) est à base d'un matériau dopant tel que l'aluminium.

14. Procédé selon la revendication 13, dans lequel le substrat semi-conducteur (1) est d'un premier type de conductivité, **caractérisé en ce que** durant la réalisation des contacts (6.1 à 6.n), le métal fondu de la couche métallique (5) crée des zones de surdopage (10.1 à 10.n) du premier type de conductivité dans le substrat semi-conducteur (1), autour des contacts métal/semi-conducteur (6.1 à 6.n).

15. Procédé de réalisation d'un dispositif semi-conducteur (100), comportant des contacts (6.1 à 6.n) réalisés selon le procédé de l'une des revendications précédentes, dans lequel le substrat semi-conducteur (1) est d'un premier type de conductivité, **caractérisé en ce qu'**il comprend les étapes suivantes :
a) cuisson du substrat semi-conducteur (1), formant, sous une autre face (3) appelée « émetteur », opposée à la base (2), une région surdopée (8) d'un second type de conductivité, opposé au premier type de conductivité ;
b) réalisation d'une couche antiréflective (11) sur l'émetteur (3) du substrat semi-conducteur (1) ;
c) dépôt d'une grille métallique (9) sur la couche antiréflective (11) ;
d) mise en contact de la grille métallique (9) avec l'émetteur (3) du substrat semi-conducteur (1) à travers la couche antiréflective (11).

16. Procédé selon la revendication 15, **caractérisé en ce que** la mise en contact de la grille métallique (9) avec l'émetteur (3) du substrat semi-conducteur (1) à travers la couche antiréflective (11) est réalisée par une cuisson de la grille métallique (9).

17. Procédé selon l'une quelconque des revendications 15 ou 16, **caractérisé en ce que** la grille métallique (9) est à base d'un métal noble tel que l'argent.

18. Procédé selon l'une quelconque des revendications 15 à 17, **caractérisé en ce que** la couche antiréflective (11) est en nitrure de silicium ou en oxyde de titane.

19. Procédé selon l'une quelconque des revendications 15 à 18, **caractérisé en ce que** le dispositif semi-conducteur (100) est une cellule solaire.

20. Dispositif à éléments en saillie (13.1 à 13.n) pour la mise en oeuvre du procédé selon l'une des revendications 1 à 19, **caractérisé en ce qu'**il comporte des éléments en saillie (13.1 à 13.n) montés sur un support (12) commun, ce support (12) incluant des moyens de chauffage (15).

21. Dispositif selon la revendication 20, **caractérisé en ce que** les extrémités des éléments en saillie (13.1 à 13.n) sont pointues.

22. Dispositif selon l'une quelconque des revendications 20 ou 21, **caractérisé en ce que** les éléments en saillie (13.1 à 13.n) sont réalisés à base de graphite ou de tungstène.

23. Dispositif selon l'une quelconque des revendications 20 à 22, **caractérisé en ce que** les moyens de chauffage (15) sont un élément résistif ou inductif.

## Claims

1. Method of forming contacts (6.1 to 6.n) between at least one metallic layer (5) and at least one semiconductor substrate (1) through at least one layer of dielectric (4) in a semiconductor device (100), said semiconductor device (100) comprising, on at least one face (2), known as "base", of the semiconductor substrate (1), the dielectric layer (4) on which is stacked the metallic layer (5), **characterised in that** the heated ends of several protruding elements (13.1 to 13.n) assembled on a support (12) are brought into contact with the metallic layer (5) simultaneously, thereby creating zones of melted metal. (14.1 to 14.n) under the heated ends of protruding elements (13.1 to 13.n), the melted metal traversing the dielectric (4) and amalgamating with the semiconductor of the substrate (1) at the level of the zones of melted metal (14.1 to 14.n), thereby creating the contacts (6.1 to 6.n).

2. Method according to claim 1, **characterised in that** the protruding elements (1.3.1 to 13.n) are arranged in a matrix on the support (12).

3. Method according to any of the previous claims, **characterised in that** the ends of the protruding elements (13.1 to 13.n) are heated to a temperature between 577°C and 1000°C.

4. Method according to any of the previous claims, **characterised in that** the application time of the heated ends of the protruding elements (13.1 to 13.n) against the metallic layer (5) is between 0.5 second and 10 seconds.

5. Method according to any of the previous claims, **characterised in that** between 500 and 35000 protruding elements (13.1 to 13.n.) are used for a surface area of semiconductor substrate (1) of 1m².

6. Method according to any of the previous claims, **characterised in that** the ends of the protruding elements (13.1 to 13.n) are of circular shape, the diameter of which is between 50 micrometers and 1 millimeter, or of quadrilateral shape, the sides of which have a dimension between 50 micrometers and 1 millimeter.

7. Method according to any of the previous claims, **characterised in that** the semiconductor substrate (1) is a crystalline substrate.

8. Method according to any of the previous claims, **characterised in that** the semiconductor substrate (1) is in monocrystalline silicon or in polycrystalline silicon.

9. Method according to any of the previous claims, **characterised in that** the dielectric layer (4) is in silicon oxide or in silicon nitride.

10. Method according to any of the previous claims, **characterised in that** the dielectric layer (4) is deposited on the semiconductor substrate (1) by a technique of plasma enhanced chemical vapour deposition.

11. Method according to any of the previous claims, **characterised in that** the metallic layer (5) is deposited on the dielectric layer (4) by evaporation, sputtering or serigraphy.

12. Method according to any of the previous claims, **characterised in that** the metallic layer (5) has a thickness of between 1 micrometer and 5 micrometers.

13. Method according to any of the previous claims, **characterised in that** the metallic layer (5) is based on a doping material such as aluminium.

14. Method according to claim 13, in which the semiconductor substrate (1) is of a first type of conductivity, **characterised in that** during the formation of the contacts (6.1 to 6.n), the melted metal of the metallic layer (5) creates overdoping zones (10.1 to 10.n) of the first type of conductivity, in the semiconductor substrate (1), around the metal/semiconductor contacts(6.1 to 6.n).

15. Method of forming a semiconductor device (100), comprising contacts (6.1 to 6.n) formed according to the method of one of the previous claims, in which the semiconductor substrate (1) is of a first type of conductivity, **characterised in that** it comprises the following steps:
a) heat treatment of the semiconductor substrate (1), forming, under another face (3) known as "emitter", opposite to the base (2), an overdoped region (8) of a second type of conductivity, opposite to the first type of conductivity;
b) formation of an antireflective layer (11) on the emitter (3) of the semiconductor substrate (1) ;
c) deposition of a metallic grid (9) on the antireflective layer (11);
d) bringing into contact the metallic grid (9) with the emitter (3) of the semiconductor substrate (1) through the antireflective layer (11).

16. Method according to claim 15, **characterised in that** the bringing into contact of the metallic grid (9) with the emitter (3) of the semiconductor substrate (1) through the antireflective layer (11) is achieved by a heat treatment of the metallic grid (9).

17. Method according to either of claims 15 or 16, **characterised in that** the metallic grid (9) is based on a noble metal such as silver.

18. Method according to any of claims 15 to 17, **characterised in that** the antireflective layer (11) is in silicon nitride or in titanium oxide.

19. Method according to any of claims 15 to 18, **characterised in that** the semiconductor device (100) is a solar cell.

20. Device with protruding elements (13.1 to 13.n) for the implementation of the method according to one of claims 1 to 19, **characterised in that** it comprises protruding elements (13.1 to 13.n) assembled on a common support (12), said support (12) including heating means (15).

21. Device according to claim 20, **characterised in that** the ends of the protruding elements (13.1 to 13.n) are pointed.

22. Device according to either of claims 20 or 21, **characterised in that** the protruding elements (13.1 to 13.n) are formed based on graphite or tungsten.

23. Device according to any of claims 20 to 22, **characterised in that** the heating means (15) are a resistive or inductive element.

## Patentansprüche

1. Verfahren zur Herstellung von Kontakten (6.1 bis 6.n) in einer Halbleitervorrichtung (100) zwischen mindestens einer Metallschicht (5) und mindestens einem Halbleitersubstrat (1) durch mindestens eine dielektrische Schicht (4) hindurch, wobei die genannte Halbleitervorrichtung (100) auf wenigstens einer "Basis" genannten Seite (2) des Halbleitersubstrats (1) die dielektrische Schicht (4) umfasst, die mit der metallischen Schicht (5) überzogenen ist,
**dadurch gekennzeichnet, dass** erhitzte Enden von mehreren auf einem Träger (12) vorhandenen vorstehenden Elementen (13.1 bis 13.n) simultan mit der metallischen Schicht (5) in Kontakt gebracht werden, so dass sich unter den erhitzten Enden der vorstehenden Elemente (13.1 bis 13.n) Zonen geschmolzenen Metalls (14.1 bis 14.n) bilden, wobei das geschmolzene Metall das Dielektrikum (4) durchquert und mit dem Halbleiter des Substrats (1) in Höhe der Zonen geschmolzenen Metalls (14.1 bis 14.n) verschmilzt und so die Kontakte (6.1 bis 6.n) schafft.

2. Verfahren nach Anspruch 1, **dadurch gekennzeichnet, dass** die vorstehenden Elemente (13.1 bis 13.n) auf dem Träger (12) matrixförmig angeordnet sind.

3. Verfahren nach einem der vorangehenden Ansprüche, **dadurch gekennzeichnet, dass** die Enden der vorstehenden Elemente (13.1 bis 13.n) auf eine zwischen 577°C und 1000°C enthaltene Temperatur erhitzt werden.

4. Verfahren nach einem der vorangehenden Ansprüche, **dadurch gekennzeichnet, dass** die Zeitdauer des Kontakts zwischen den erhitzten Enden der vorstehenden Elemente (13.1 bis 13.n) und der metallischen Schicht (5) zwischen 0,5 Sekunden und 10 Sekunden enthalten ist.

5. Verfahren nach einem der vorangehenden Ansprüche, **dadurch gekennzeichnet, dass** für eine Fläche von ungefähr 1 m² des Halbleitersubstrats (1) zwischen 500 und 35 000 vorstehende Elemente (13.1 bis 13.n) benutzt werden.

6. Verfahren nach einem der vorangehenden Ansprüche, **dadurch gekennzeichnet, dass** die Enden der vorstehenden Elemente (13.1 bis 13.n) die Form von Kreisen mit Durchmessern zwischen 50 µm und 1 mm oder von Vierecken mit Seitenlängen zwischen 50 µm und 1 mm haben.

7. Verfahren nach einem der vorangehenden Ansprüche, **dadurch gekennzeichnet, dass** das Halbleitersubstrat (1) ein kristallines Substrat ist.

8. Verfahren nach einem der vorangehenden Ansprüche, **dadurch gekennzeichnet, dass** das Halbleitersubstrat (1) aus monokristallinem Silicium oder aus polykristallinem Silicium ist.

9. Verfahren nach einem der vorangehenden Ansprüche, **dadurch gekennzeichnet, dass** die dielektrische Schicht (4) aus Siliciumoxid oder Siliciumnitrid ist.

10. Verfahren nach einem der vorangehenden Ansprüche, **dadurch gekennzeichnet, dass** die dielektrische Schicht (4) auf dem Halbleitersubstrat (1) mit Hilfe einer PECVD-Technik abgeschieden wird.

11. Verfahren nach einem der vorangehenden Ansprüche, **dadurch gekennzeichnet, dass** die metallische Schicht (5) auf die dielektrischen Schicht (4) durch Aufdampfen, Sputtern oder Siebdruck aufgebracht wird.

12. Verfahren nach einem der vorangehenden Ansprüche, **dadurch gekennzeichnet, dass** die metallische Schicht (5) eine Dicke zwischen 1 µm und 5 µm hat.

13. Verfahren nach einem der vorangehenden Ansprüche, **dadurch gekennzeichnet, dass** die metallische Schicht (5) auf einem dotierenden Material wie Aluminium basiert.

14. Verfahren nach Anspruch 13, bei dem das Halbleitersubstrat (1) einen ersten Konduktivitätstyp aufweist, **dadurch gekennzeichnet, dass** während der Realisierung der Kontakte (6.1 bis 6.n) das geschmolzene Metall der metallischen Schicht (5) Überdotierungszonen (10.1 bis 10.n) des ersten Konduktivitätstyps in dem Halbleitersubstrat (1) erzeugt, um die Metall/Halbleiter-Kontakte (6.1 bis 6.n) herum.

15. Verfahren zur Herstellung einer Halbleitervorrichtung (100) mit Kontakten (6.1 bis 6.n), realisiert gemäß dem Verfahren nach einem der vorangehenden Ansprüche, bei dem das Halbleitersubstrat (1) einen ersten Konduktivitätstyp aufweist, **dadurch gekennzeichnet, dass** es die folgenden Schritte umfasst:
a) Brennen des Halbleitersubstrats (1), so dass sich unter einer "Emitter" genannten anderen Seite (3), der Basis (2) entgegengesetzten, ein überdotierter Bereich (8) eines dem ersten Konduktivitätstyp entgegengesetzten zweiten Konduktivitätstyps bildet;
b) Realisieren einer Antireflexionsschicht (11) auf dem Emitter (3) des Halbleitersubstrats (1);
c) Abscheiden eines metallischen Gitters (9) auf der Antireflexionsschicht (11);
d) Herstellen des Kontakts zwischen dem metallischen Gitter (9) und dem Emitter (3) des Halbleitersubstrats (1) durch die Antireflexionsschicht (11) hindurch.

16. Verfahren nach Anspruch 15, **dadurch gekennzeichnet, dass** die Herstellung des Kontakts zwischen dem metallischen Gitter (9) und dem Emitter (3) des Halbleitersubstrats (1) durch die Antireflexionsschicht (11) hindurch durch ein Brennen bzw. Einbrennen des metallischen Gitters (9) realisiert wird.

17. Verfahren nach einem der Ansprüche 15 oder 16, **dadurch gekennzeichnet, dass** das metallische Gitter (9) auf einem Edelmetall wie etwa Silber beruht.

18. Verfahren nach einem der Ansprüche 15 bis 17, **dadurch gekennzeichnet, dass** die Antireflexionsschicht (11) aus Siliciumnitrid oder aus Titanoxid ist.

19. Verfahren nach einem der Ansprüche 15 bis 18, **dadurch gekennzeichnet, dass** die Halbleifiervorrichtung (100) eine Solarzelle ist.

20. Vorrichtung mit vorstehenden Elementen (13.1 bis 13.n) für die Anwendung des Verfahrens nach einem der Ansprüche 1 bis 19, **dadurch gekennzeichnet, dass** sie auf einem gemeinsamen Träger (12) vorhandene vorstehende Elemente (13.1 bis 13.n) umfasst, wobei dieser Träger (12) Heizeinrichtungen (15) enthält.

21. Vorrichtung nach Anspruch 20, **dadurch gekennzeichnet, dass** die Enden der vorstehenden Elemente (13.1 bis 13.n) spitz sind.

22. Vorrichtung nach einem der Ansprüche 20 oder 21, **dadurch gekennzeichnet, dass** die vorstehenden Elemente (13.1 bis 13.n) auf der Basis von Graphit oder Wolfram realisiert sind.

23. Vorrichtung nach einem der Ansprüche 20 bis 22, **dadurch gekennzeichnet, dass** die Heizeinrichtungen (15) ein resistives oder induktives Element sind.
